# EUROPEAN PATENT SPECIFICATION

(11) **EP 4 421 498 B1**
(45) Date of publication and mention of the grant of the patent: **15.04.2026**
(21) Application number: 23734892.5
(22) Date of filing: 21.03.2023
(51) Int. Cl.: G01R 1/04, G01R 1/06, G01R 31/385, G01R 31/388, G01R 31/36

(54) **BATTERY TRAY AND TESTING SYSTEM FOR BATTERY**
BATTERIEFACH UND PRÜFSYSTEM FÜR BATTERIE
PLATEAU DE BATTERIE ET SYSTÈME DE TEST DE BATTERIE

(30) Priority: 10.01.2023 CN 202320071459 U
(43) Date of publication of application: 28.08.2024
(73) Proprietor: Contemporary Amperex Technology (Hong Kong) Limited, Central, Central And Western District (HK)
(72) Inventor: LI, Yankun, Ningde City Fujian 352100 (CN); LIU, Bo, Ningde City Fujian 352100 (CN); LI, Haiyang, Ningde City Fujian 352100 (CN); GUO, Lixin, Ningde City Fujian 352100 (CN); REN, Shaoteng, Ningde City Fujian 352100 (CN)
(74) Representative: Gong, Jinping
(86) International application number: PCT/CN2023/082924
(87) International publication number: WO 2024/148682

(56) References cited:
- WO-A1-2022/167955
- CN-A- 108 490 367
- CN-A- 108 490 367
- CN-A- 109 541 477
- CN-A- 110 794 318
- CN-A- 111 948 550
- CN-A- 113 540 632
- CN-A- 114 787 639
- CN-A- 115 207 553
- CN-U- 215 768 925
- TW-A- 201 211 567
- US-A- 5 914 609

## Description

### CROSS-REFERENCE TO RELATED APPLICATIONS

This application claims priority to Chinese patent application No. 202320071459.5, filed on January 10, 2023.

### TECHNICAL FIELD

This application relates to the technical field of testing devices for a battery, and in particular, to a testing system for battery as specified in any of claims 1-12.

### BACKGROUND

A traction battery tray is disclosed in the related art, which integrates two forms of cooling: air cooling and water cooling, and uses a flow channel through which a cooling liquid flows unidirectionally, so as to improve a circulation speed of the cooling liquid in the tray, thereby improving a heat dissipation effect. However, the traction battery tray is configured to carry only batteries, featuring a single function. In addition, the tray is a disposable structure and cannot be recycled and reused. Testing systems for a battery according to the state of the art are known from WO2022/167955 A1, TW201211567 A and CN108490367 A.

### SUMMARY

The present invention is defined by the appended claims. In view of the foregoing problems, this application provides a battery tray, and the battery tray can implement synchronous tests for current, voltage, pressure, and temperature, so that testing time for battery is greatly shortened, thereby improving testing efficiency and reducing testing costs.

This application further proposes a testing system for battery that has the foregoing battery tray.

According to a first aspect, this application provides a testing system for battery, including: a base; a battery tray, the battery tray is detachably disposed at the base; a movable testing assembly, and a drive means; wherein the battery tray, including: a tray body configured to support a battery; a testing connection bar, where the testing connection bar is disposed on the tray body and has a plurality of signal collection portions, and the plurality of signal collection portions include a current collection portion, a voltage collection portion, a pressure collection portion, and a temperature collection portion, wherein each signal collection portion includes two signal collection terminals, and a plurality of signal collection terminals are spaced apart along a length direction of the testing connection bar; and a positioning member, where the positioning member is disposed on the tray body and configured to position the battery; where the testing assembly includes a plurality of signal testing portions; where the drive means is configured to drive the testing assembly to move so that the plurality of signal testing portions synchronously dock with the plurality of signal collection portions in one-to-one correspondence; and wherein each signal testing portion comprises two signal testing probes, and a plurality of signal testing probes are in one-to-one correspondence with a plurality of signal collection terminals.

In the technical solution in this embodiment of this application, the tray body has a function of carrying a battery, which helps transport the battery. The current collection portion, the voltage collection portion, the pressure collection portion, and the temperature collection portion are disposed on the testing connection bar, so that the testing connection bar integrates a testing function for current, voltage, pressure, and temperature. In this way, the current, voltage, pressure, and temperature can be synchronously tested, so that testing time for battery is greatly shortened, thereby improving testing efficiency and reducing testing costs. With the positioning member disposed, the battery can be positioned to ensure that the battery can be quickly installed on the tray body, thereby further improving testing efficiency.

In some embodiments of the current disclosure, each signal collection portion includes two signal collection terminals, and a plurality of signal collection terminals are spaced apart along a length direction of the testing connection bar, which can implement an orderly arrangement of the plurality of signal collection terminals. In this way, it is convenient for the signal collection portion to connect to a testing circuit on the battery and a signal testing probe of a testing system.

In some embodiments, the testing connection bar is disposed at an end of the tray body in a length direction, and the length direction of the testing connection bar extends along a width direction of the tray body. The testing connection bar is disposed at the end of the tray body in the length direction of the tray body, so that a middle position of the tray body is not occupied, thereby reserving a space on the tray body for supporting the battery.

In some embodiments, the battery tray further includes: a current collection wire, where the current collection wire is connected to the current collection portion, and the current collection portion is connected to the battery via the current collection wire; a voltage collection wire, where the voltage collection wire is connected to the voltage collection portion, and the voltage collection portion is connected to the battery via the voltage collection wire; a pressure collection wire, where the pressure collection wire is connected to the pressure collection portion, and the pressure collection portion is connected to a pressure sensor on the battery via the pressure collection wire; and a temperature collection wire, where the temperature collection wire is connected to the temperature collection portion, and the temperature collection portion is connected to a temperature sensor on the battery via the temperature collection wire. It is convenient and easy to implement the connection.

In some embodiments, the positioning member and the testing connection bar are spaced apart along the length direction of the tray body so that after the battery is installed on the tray body, the battery and the testing connection bar are arranged along the length direction of the tray body. In this way, an orderly arrangement of the battery and testing connection bar can be implemented. In addition, a space on the tray body can be used effectively to carry batteries of different sizes.

In some embodiments, the positioning member includes: a first positioning plate, where the first positioning plate extends along the length direction of the tray body; and a second positioning plate, where the second positioning plate extends along the width direction of the tray body, and an end of the second positioning plate is connected to an end of the first positioning plate. The second positioning plate is provided directly opposite the testing connection bar. At least one of the first positioning plate and the second positioning plate is suitable for stopping the battery. The positioning member including the first positioning plate and the second positioning plate is configured to increase a method of positioning the battery, so that the battery can be positioned by selecting the first positioning plate or the second positioning plate as required.

In some embodiments, the first positioning plate and the second positioning plate each are provided with a plurality of positioning holes, and straps can be used to pass through the positioning holes to tie the battery to the first positioning plate or the second positioning plate, thereby implementing positioning and installation of the battery. In this way, the battery is easy to install and disassemble and simple to operate.

In some embodiments, the tray body is provided with buffer portions on outer surfaces of two side walls in the width direction to prevent the tray body accommodating the battery from shaking during a battery testing process and to ensure stability of a testing signal.

In the technical solution in this embodiment of this application, the tray body accommodating the battery is installed at the base and the drive means is provided. The drive means can be used to drive the plurality of signal testing portions to move synchronously, so that the plurality of signal testing portions may synchronously dock with the plurality of signal collection portions of the battery tray. In this way, synchronous tests for current, voltage, pressure, and temperature can be implemented, so that testing time for battery is greatly shortened, thereby improving testing efficiency and reducing testing costs.

In some embodiments, the testing assembly further includes: a fastening base. The drive means is connected to the fastening base to drive the fastening base to move, the plurality of signal testing portions are fastened to the fastening base to move synchronously with the fastening base, and positions of the plurality of signal testing portions are in one-to-one correspondence with positions of the plurality of signal collection portions. The plurality of signal testing portions are fastened to the fastening base, so that the drive means drives the plurality of signal testing portions to move synchronously to implement synchronous docking between the plurality of signal testing portions and the plurality of signal collection portions of the battery tray. In this way, synchronous tests for current, voltage, pressure, and temperature can be implemented, so that testing time for battery is greatly shortened, thereby improving testing efficiency and reducing testing costs.

In some embodiments, the base includes a supporting portion and two restraint portions. The two restraint portions are disposed opposite each other in a width direction of the tray body and located on two sides of the supporting portion, and each restraint portion extends along a length direction of the tray body. The tray body is supported by the supporting portion and located between the two restraint portions. The battery tray can be supported by the supporting portion, and the battery tray can be restrained by the two restraint portions to ensure reliability and stability during the installation of the battery tray, thereby ensuring stability of a testing signal.

In some embodiments, the bottom of the tray body has a convex portion that extends along the length direction of the tray body, an upper surface of the supporting portion has a plurality of rolling portions arranged along the length direction of the tray body, and the convex portion is in rolling fit with the rolling portions. The upper surface of the supporting portion is provided with the plurality of rolling portions. A position of the battery tray at the base can be fine-tuned by the plurality of rolling portions so that the battery can be installed at a position to be tested and testing requirements are met.

In some embodiments, upper ends of the two restraint portions are provided with guide portions that extend upward away from each other. The guide portion can guide the tray body accommodating the battery to the base, so that the battery can be installed at the position to be tested and the testing requirements can be met.

In some embodiments, an end of the supporting portion is further provided with a stop portion, and the stop portion is suitable for stopping at an end of the tray body in the length direction. The stop portion is disposed at the end of the supporting portion, so that the stop portion can stop the tray body accommodating the battery, thereby confining the tray body accommodating the battery to the base and preventing the tray body accommodating the battery from detaching from the base.

Some additional aspects and advantages of this application are provided in the following description, and some other additional aspects and advantages of this application become apparent in the following description or are understandable by practicing this application.

### BRIEF DESCRIPTION OF DRAWINGS

To describe the technical solutions in the embodiments of this application more clearly, the following briefly describes the accompanying drawings required for describing the embodiments. It is appreciated that the accompanying drawings below only show some embodiments of this application and thus should not be considered as limitations on the scope. A person of ordinary skill in the art may still derive other related drawings from the accompanying drawings without creative efforts.
FIG. 1 is a schematic structural diagram of a battery tray according to some embodiments of this application;
FIG. 2 is a side view of the battery tray shown in FIG. 1 from an angle of view;
FIG. 3 is a schematic structural diagram of a testing system for battery according to some embodiments of this application;
FIG. 4 is a side view of the testing system for battery shown in FIG. 3 from an angle of view; and
FIG. 5 is a side view of the testing system for battery shown in FIG. 3 from another angle of view.

Reference signs:
100. battery tray;
11. tray body;
12. testing connection bar; 120. signal collection portion; 121. current collection portion; 122. voltage collection portion; 123. pressure collection portion; 124. temperature collection portion;
13. positioning member; 130. positioning hole; 131. first positioning plate; 132. second positioning plate;
14. buffer portion; 15. convex portion; 151. guide surface;
200. testing system;
21. base; 211. supporting portion; 212. restraint portion; 213. guide portion; 214. stop portion;
22. testing assembly; 221. fastening base; 222. signal testing portion;
23. drive means;
241. connecting base; 242. connecting rod; and 243. elastic member.

### DESCRIPTION OF EMBODIMENTS

To make the objectives, technical solutions, and advantages of the embodiments of this application clearer, the following clearly describes the technical solutions in the embodiments of this application with reference to the accompanying drawings in the embodiments of this application.

Unless otherwise defined, all technical and scientific terms used in this application shall have the same meanings as commonly understood by those skilled in the art to which this application relates. The terms used in the specification of this application are intended to merely describe the specific embodiments rather than to limit this application. The terms "include", "comprise", and any variations thereof in the specification and claims of this application as well as the foregoing description of drawings are intended to cover non-exclusive inclusions. In the specification, claims, or accompanying drawings of this application, the terms "first", "second", and the like are intended to distinguish between different objects rather than to indicate a particular order or relative importance.

Reference to "embodiment" in this application means that specific features, structures, or characteristics described with reference to the embodiment may be included in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art that the embodiments described herein may be combined with other embodiments.

In the description of this application, it should be noted that unless otherwise specified and defined explicitly, the terms "mount", "connect", "join", and "attach" should be understood in their general senses. For example, they may refer to a fixed connection, a detachable connection, or an integral connection, and may refer to a direct connection, an indirect connection via an intermediate medium, or an internal communication between two elements. A person of ordinary skill in the art can understand specific meanings of these terms in this application as appropriate to specific situations.

The term "and/or" in this application is only an associative relationship for describing associated objects, indicating that three relationships may be present. For example, A and/or B may indicate three cases: presence of only A; presence of both A and B; and presence of only B. In addition, the character "/" in this application generally indicates an "or" relationship between contextually associated objects.

In the embodiments of this application, the same reference signs denote the same components. For brevity, in different embodiments, detailed descriptions of the same components are not repeated. It should be understood that, as shown in the accompanying drawings, sizes such as thickness, length, and width of various components and sizes such as thickness, length, and width of integrated apparatuses in the embodiments of this application are merely for illustrative purposes and should not constitute any limitations on this application.

During a battery production process, a battery tray is required to carry a batch of batteries to help transport the batteries. On a battery production line, battery models are frequently changed based on actual production needs, and batteries of different models also have different sizes. When battery sizes are changed, the battery tray needs to be replaced or adjusted.

A related art discloses a traction battery tray, which may be configured to carry the battery and help transport the battery, and the traction battery tray further integrates two forms of cooling: air cooling and water cooling, and uses a flow channel through which a cooling liquid flows unidirectionally to improve a circulation speed of the cooling liquid in the tray, thereby improving a heat dissipation effect. However, the traction battery tray is configured to carry only batteries, featuring a single function. In addition, the tray is a disposable structure, and cannot be recycled and reused.

In view of this, an embodiment of this application provides a battery tray having a testing connection bar integrating a plurality of signal collection portions (including a current collection portion, a voltage collection portion, a pressure collection portion, and a temperature collection portion) to implement synchronous tests for current, voltage, pressure, and temperature so that testing time for battery is greatly shortened, thereby improving testing efficiency and reducing testing costs.

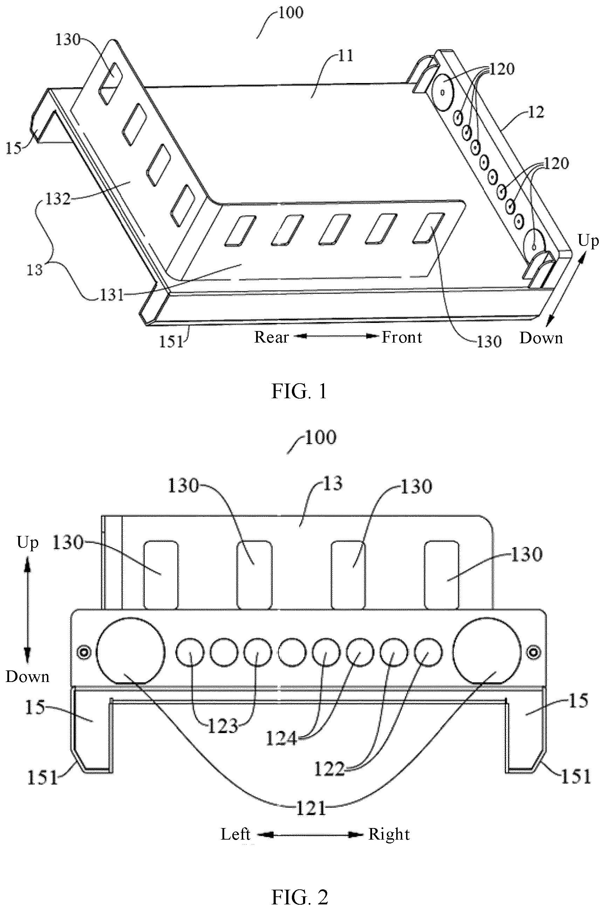

The battery tray 100 according to an embodiment of this application is described below with reference to FIG. 1 to FIG. 5.

As shown in FIG. 1 and FIG. 2, the battery tray 100 in this embodiment of this application includes a tray body 11 and a testing connection bar 12. The tray body 11 is configured to support a battery, the testing connection bar 12 is disposed on the tray body 11, and the testing connection bar 12 has a plurality of signal collection portions 120. That is, the plurality of signal collection portions 120 are integrated.

The plurality of signal collection portions 120 include a current collection portion 121, a voltage collection portion 122, a pressure collection portion 123, and a temperature collection portion 124.

Specifically, the current collection portion 121 may be connected to the battery so that a current of the battery may be measured by using the current collection portion 121. The voltage collection portion 122 may be connected to the battery so that a voltage of the battery may be measured by using the voltage collection portion 122. The pressure collection portion 123 may be connected to a pressure sensor on the battery so that a pressure applied by the clamp on the tray body 11 to the battery may be measured by using the pressure collection portion 123. The temperature collection portion 124 may be connected to a temperature sensor on the battery so that a temperature of the battery may be measured by using the temperature collection portion 124.

Further, the battery tray 100 further includes a positioning member 13. The positioning member 13 is disposed on the tray body 11, and the positioning member 13 is configured to position the battery to ensure that the battery can be quickly installed on the tray body 11, thereby further improving testing efficiency.

In the technical solution in this embodiment of this application, the tray body 11 has a function of carrying the battery, which helps transport the battery. The current collection portion 121, the voltage collection portion 122, the pressure collection portion 123, and the temperature collection portion 124 are disposed on the testing connection bar 12, so that the testing connection bar 12 integrates a testing function for current, voltage, pressure, and temperature. In this way, the current, voltage, pressure, and temperature can be synchronously tested, so that testing time for battery is greatly shortened, thereby improving testing efficiency and reducing testing costs. With the positioning member 13 disposed, the battery can be positioned to ensure that the battery can be quickly installed on the tray body 11, thereby further improving testing efficiency.

As shown in FIG. 1 and FIG. 2, in some embodiments, each signal collection portion 120 includes two signal collection terminals.

Specifically, the current collection portion 121 includes a positive terminal for collecting a current signal and a negative terminal for collecting a current signal. The positive terminal for collecting a current signal and the negative terminal for collecting a current signal are connected to the battery, thereby forming a testing circuit for current.

The voltage collection portion 122 includes a positive terminal for collecting a voltage signal and a negative terminal for collecting a voltage signal. The positive terminal for collecting a voltage signal and the negative terminal for collecting a voltage signal are connected to the battery, thereby forming a testing circuit for voltage.

The pressure collection portion 123 includes a positive terminal for collecting a pressure signal and a negative terminal for collecting a pressure signal. The positive terminal for collecting a pressure signal and the negative terminal for collecting a pressure signal are connected to a pressure sensor on the battery, thereby forming a testing circuit for pressure.

The temperature collection portion 124 includes a positive terminal for collecting a temperature signal and a negative terminal for collecting a temperature signal. The positive terminal for collecting a temperature signal and the negative terminal for collecting a temperature signal are connected to a temperature sensor on the battery, thereby forming a testing circuit for temperature.

The plurality of signal collection terminals are spaced apart along a length direction of the testing connection bar 12, which can implement an orderly arrangement of the plurality of signal collection terminals. In this way, it is convenient for the signal collection portion to connect to a testing circuit on the battery and a signal testing probe of a testing system.

As shown in FIG. 1 and FIG. 2, in some embodiments, the testing connection bar 12 is disposed at an end of the tray body 11 in a length direction (direction from the front to the rear shown in FIG. 1), and a length direction of the testing connection bar 12 extends along a width direction of the tray body 11 (direction from the left to the right shown in FIG. 2).

The testing connection bar 12 is disposed at an end of the tray body 11 in the length direction, so that a middle position of the tray body 11 is not occupied, thereby reserving a space on the tray body 11 to support the battery.

In some embodiments, the battery tray 100 further includes a current collection wire, a voltage collection wire, a pressure collection wire, and a temperature collection wire. The current collection wire is connected to the current collection portion 121, and the current collection portion 121 is connected to the battery via the current collection wire. The voltage collection wire is connected to the voltage collection portion 122, and the voltage collection portion 122 is connected to the battery via the voltage collection wire. The pressure collection wire is connected to the pressure collection portion 123, and the pressure collection portion 123 is connected to a pressure sensor on the battery via the pressure collection wire. The temperature collection wire is connected to the temperature collection portion 124, and the temperature collection portion 124 is connected to a temperature sensor on the battery via the temperature collection wire. It is convenient and easy to implement the connection.

Specifically, the current collection wire, the voltage collection wire, the pressure collection wire, and the temperature collection wire are correspondingly connected to the current collection portion 121, the voltage collection portion 122, the pressure collection portion 123, and the temperature collection portion 124 on the testing connection bar 12 respectively. After the battery is installed on the tray body 11, the current collection wire may be connected to the battery, the voltage collection wire may be connected to the battery, the pressure collection wire may be connected to the pressure sensor on the battery, and the temperature collection wire may be connected to the temperature sensor on the battery. Then, the tray body 11 accommodating the battery is installed on the following base 21, and ultimately, the plurality of signal testing portions 222 synchronously dock with the plurality of signal collection portions 120 in one-to-one correspondence to implement integrated testing for current, voltage, pressure, and temperature.

In some embodiments, the testing connection bar 12 is a copper bar.

In some embodiments, the tray body 11 may be made of sheet metal and bakelite, which is conducive to improvement of wear resistance of the tray body 11 and prolonging of a service life. Due to high structural strength of the tray body 11, the tray body can carry batteries of different weights. For example, the tray body can carry 1 kg to 50 kg of batteries, which can make full use of a space of the battery tray 100, thereby implementing recycling of the battery tray 100.

In some embodiments, the positioning member 13 and the testing connection bar 12 are spaced apart along the length direction of the tray body 11, so that after the battery is installed on the tray body 11, the battery and the testing connection bar 12 are arranged along the length direction of the tray body 11, which can not only implement an orderly arrangement of the battery and the testing connection bar 12, but also effectively use a space of the tray body 11 to carry batteries of different sizes.

As shown in FIG. 1, in some embodiments, the positioning member 13 includes a first positioning plate 131 and a second positioning plate 132. The first positioning plate 131 extends along the length direction of the tray body 11, and the second positioning plate 132 extends along the width direction of the tray body 11. An end of the second positioning plate 132 is connected to an end of the first positioning plate 131, and the second positioning plate 132 is provided directly opposite the testing connection bar 12. At least one of the first positioning plate 131 and the second positioning plate 132 is suitable for stopping the battery.

Specifically, when the battery is installed on the tray body 11, one side of the battery can abut against the first positioning plate 131 to position the battery by using the first positioning plate 131, and one side of the battery can also abut against the second positioning plate 132 to position the battery by using the second positioning plate 132. Specifically, an appropriate positioning plate can be selected based on a requirement such as a shape or a size of the battery to implement positioning and installation of the battery on the tray body 11.

Therefore, the positioning member 13 including the first positioning plate 131 and the second positioning plate 132 is configured to increase a method of positioning the battery, so that the battery can be positioned by selecting the first positioning plate 131 or the second positioning plate 132 as required.

In some embodiments, the first positioning plate 131 and the second positioning plate 132 each are provided with a plurality of positioning holes 130, and straps can be used to pass through the positioning holes 130 to tie the battery to the first positioning plate 131 or to the second positioning plate 132, thereby implementing positioning and installation of the battery. In this way, the battery is easy to install and disassemble and simple to operate.

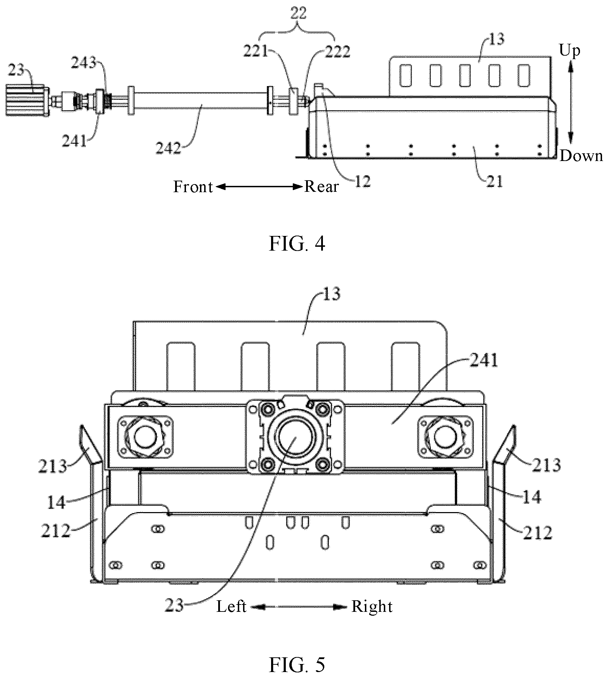

As shown in FIG. 2 and FIG. 5, in some embodiments, the tray body 11is provide with buffer portions 14 on outer surfaces of two side walls in the width direction to prevent the tray body 11 accommodating the battery from shaking during a battery testing process and to ensure stability of a testing signal.

A testing system 200 for battery in this embodiment of this application is described below with reference to FIG. 1 to FIG. 5.

As shown in FIG. 1 to FIG. 3, the testing system 200 for battery in this embodiment of this application includes a base 21, the battery tray 100 in the foregoing embodiments, a movable testing assembly 22, and a drive means 23.

The battery tray 100 is detachably disposed at the base 21, and the testing assembly 22 includes a plurality of signal testing portions 222. The drive means 23 is connected to the testing assembly 22, and the drive means 23 is configured to drive the testing assembly 22 to move so that the plurality of signal testing portions 222 can synchronously dock with the plurality of signal collection portions 120 in one-to-one correspondence.

In the technical solution in this embodiment of this application, the tray body 11 accommodating the battery is installed at the base 21 and the drive means 23 is provided. The drive means 23 can be used to drive the plurality of signal testing portions 222 to move synchronously, so that the plurality of signal testing portions 222 may synchronously dock with the plurality of signal collection portions 120 of the battery tray 100. In this way, synchronous tests for current, voltage, pressure, and temperature can be implemented, so that testing time for battery is greatly shortened, thereby improving testing efficiency and reducing testing costs.

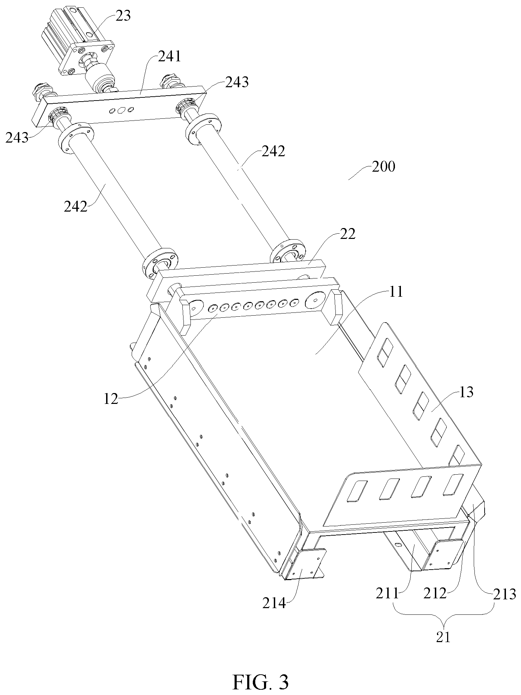

As shown in FIG. 3 to FIG. 5, in some embodiments, the testing assembly 22 further includes a fastening base 221. The plurality of signal testing portions 222 are fastened to the fastening base 221, and the plurality of signal testing portions 222 are in one-to-one correspondence with the plurality of signal collection portions 120. The drive means 23 is connected to the fastening base 221, and the drive means 23 can drive the fastening base 221 to move. When the fastening base 221 moves, the plurality of signal testing portions 222 can move synchronously with the fastening base 221.

Therefore, the plurality of signal testing portions 222 is fastened to the fastening base 221, the drive means 23 is configured to drive the plurality of signal testing portions 222 to move synchronously, so that the plurality of signal testing portions 222 may synchronously dock with the plurality of signal collection portions 120 of the battery tray 100. In this way, synchronous tests for current, voltage, pressure, and temperature can be implemented, so that testing time for battery is greatly shortened, thereby improving testing efficiency and reducing testing costs.

Each signal collection portion 120 includes two signal collection terminals. Each signal testing portion 222 includes two signal testing probes, and a plurality of signal testing probes are in one-to-one correspondence with a plurality of signal collection terminals. The drive means 23 can drive the fastening base 221 to move, and when the fastening base 221 moves, the plurality of signal testing probes can move synchronously with the fastening base 221, so that the plurality of signal testing probes synchronously dock with the plurality of signal collection terminals in one-to-one correspondence to implement fast testing.

As shown in FIG. 3, the testing system 200 for battery further includes a connecting base 241, and a plurality of connecting rods 242 and elastic members 243. Two ends of each connecting rod 242 are connected to the connecting base 241 and the fastening base 221 respectively. The elastic member 243 is sleeved on the connecting rod 242, and the elastic member 243 abuts against the connecting rod 242 and the connecting base 241. The drive means 23 is connected to the connecting base 241 to drive the connecting base 241 to move, and the connecting base 241 can drive the fastening base 221 to move by using the connecting rod 242, to ultimately drive the plurality of signal testing portions 222 to move synchronously, featuring simple structure and easy operation.

In some embodiments, the base 21 includes a supporting portion 211 and two restraint portions 212. The two restraint portions 212 are disposed opposite each other in a width direction of the tray body 11, and the two restraint portions 212 are on two sides of the supporting portion 211. Each restraint portion 212 extends along a length direction of the tray body 11, the tray body 11 is supported by the supporting portion 211, and the tray body 11 is located between the two restraint portions 212.

Therefore, the base 21 including a supporting portion 211 and two restraint portions 212 is configured. The battery tray 100 can be supported by the supporting portion 211 and the battery tray 100 can be restrained by the two restraint portions 212 to ensure reliability and stability during the installation of the battery tray 100, thereby ensuring stability of a testing signal.

In some embodiments, the bottom of the tray body 11 has a convex portion 15, and the convex portion 15 extends along the length direction of the tray body 11. An upper surface of the supporting portion 211 has a plurality of rolling portions (not shown in the figure), and the plurality of rolling portions are arranged along the length direction of the tray body 11. The convex portion 15 is in rolling fit with the rolling portions.

There, the upper surface of the supporting portion 211 is provided with the plurality of rolling portions. A position of the battery tray 100 at the base 21 can be fine-tuned by using the plurality of rolling portions so that the battery can be installed at a position to be tested and testing requirements can be met.

There are two convex portions 15. The two convex portions 15 are spaced apart along the width direction of the tray body 11, and each convex portion 15 extends along the length direction of the tray body 11. A guide surface 151 is provided on the side walls, facing away from each other, of the two convex portions 15 to ensure that the battery tray 100 can be installed at the base 21 smoothly.

As shown in FIG. 3, in some embodiments, upper ends of the two restraint portions 212 are provided with guide portions 213, and the two guide portions 213 extend upward away from each other. The two guide portions 213 can guide the tray body 11 accommodating the battery to the base 21, so that the battery is installed at a position to be tested and testing requirements are met.

In some embodiments, an end of the supporting portion 211 is further provided with a stop portion 214. The stop portion 214 is suitable for stopping at an end of the tray body 11 in the length direction.

Therefore, the stop portion 214 is disposed at an end of the supporting portion 211, so that the stop portion 214 can stop the tray body 11 accommodating the battery, thereby confining the tray body 11 accommodating the battery to the base 21 and preventing the battery tray 100 from detaching from the base 21.

It can be understood that other composition and operations of the battery, the battery tray 100, and the testing system 200 for battery according to the embodiments of this application are known to a person of ordinary skill in the art. Details are not described herein.

It should be noted that, in absence of conflicts, the embodiments and features in the embodiments in this application may be combined with each other.

## Claims

1. A testing system (200) for a battery, comprising:
a base (21), a battery tray (100), a movable testing assembly (22), and a drive means (23);
wherein the battery tray (100) is detachably disposed at the base (21), and the battery tray (100) comprises a tray body (11), a testing connection bar (12), and a positioning member (13);
wherein the tray body (11), configured to support a battery;
wherein the testing connection bar (12) is disposed on the tray body (11) and has a plurality of signal collection portions (120), and the plurality of signal collection portions (120) comprise a current collection portion (121), a voltage collection portion (122), a pressure collection portion (123), and a temperature collection portion (124); wherein each signal collection portion (120) comprises two signal collection terminals, and a plurality of signal collection terminals are spaced apart along a length direction of the testing connection bar (12); and
wherein the positioning member (13) is disposed on the tray body (11) and configured to position the battery;
wherein the testing assembly (22) comprises a plurality of signal testing portions (222);
wherein the drive means (23) is configured to drive the testing assembly (22) to move so that the plurality of signal testing portions (222) synchronously dock with the plurality of signal collection portions (120) in one-to-one correspondence; and
wherein each signal testing portion (222) comprises two signal testing probes, and a plurality of signal testing probes are in one-to-one correspondence with a plurality of signal collection terminals.

2. The testing system (200) for a battery according to claim 1, wherein the testing connection bar (12) is disposed at an end of the tray body (11) in a length direction, and the length direction of the testing connection bar (12) extends along a width direction of the tray body (11).

3. The testing system (200) for a battery according to any one of claims 1 to 2, wherein the battery tray further comprises:
a current collection wire, wherein the current collection wire is connected to the current collection portion (121), and the current collection portion (121) is connected to the battery via the current collection wire;
a voltage collection wire, wherein the voltage collection wire is connected to the voltage collection portion (122), and the voltage collection portion (122) is connected to the battery via the voltage collection wire;
a pressure collection wire, wherein the pressure collection wire is connected to the pressure collection portion (123), and the pressure collection portion (123) is connected to a pressure sensor on the battery via the pressure collection wire; and
a temperature collection wire, wherein the temperature collection wire is connected to the temperature collection portion (124), and the temperature collection portion (124) is connected to a temperature sensor on the battery via the temperature collection wire.

4. The testing system (200) for a battery according to any one of claims 1 to 3, wherein the positioning member (13) and the testing connection bar (12) are spaced apart along a length direction of the tray body (11).

5. The testing system (200) for a battery according to any one of claims 1 to 4, wherein the positioning member (13) comprises:
a first positioning plate (131), wherein the first positioning plate (131) extends along a length direction of the tray body (11); and
a second positioning plate (132), wherein the second positioning plate (132) extends along a width direction of the tray body (11), and an end of the second positioning plate (132) is connected to an end of the first positioning plate (131);
wherein the second positioning plate (132) is disposed directly opposite the testing connection bar (12), and at least one of the first positioning plate (131) and the second positioning plate (132) is suitable for stopping the battery.

6. The testing system (200) for a battery according to claim 5, wherein the first positioning plate (131) and the second positioning plate (132) each are provided with a plurality of positioning holes (130).

7. The testing system (200) for a battery according to any one of claims 1 to 6, wherein the tray body (11) is provided with buffer portions (14) on outer surfaces of two side walls in a width direction.

8. The testing system for a battery according to any one of claims 1 to 7, wherein the testing assembly (22) further comprises:
a fastening base (221), wherein the drive means (23) is connected to the fastening base (221) to drive the fastening base (221) to move, the plurality of signal testing portions (222) are fastened to the fastening base (221) to move synchronously with the fastening base (221), and positions of the plurality of signal testing portions (222) are in one-to-one correspondence with positions of the plurality of signal collection portions (120).

9. The testing system for a battery according to any one of claims 1 to 7, wherein the base comprises:
a supporting portion (211); and
two restraint portions (212), wherein the two restraint portions (212) are disposed opposite each other in a width direction of the tray body (11) and located on two sides of the supporting portion (211), and each restraint portion (212) extends along a length direction of the tray body (11);
wherein the tray body (11) is supported by the supporting portion (211) and located between the two restraint portions (212).

10. The testing system for a battery according to claim 9, wherein the bottom of the tray body (11) has a convex portion (15) that extends along the length direction of the tray body (11), an upper surface of the supporting portion (211) has a plurality of rolling portions arranged along the length direction of the tray body (11), and the convex portion (15) is in rolling fit with the rolling portions.

11. The testing system for a battery according to claim 9, wherein upper ends of the two restraint portions (212) are provided with guide portions (213) that extend upward away from each other.

12. The testing system for a battery according to claim 9, wherein an end of the supporting portion (211) is further provided with a stop portion (214), and the stop portion (214) is suitable for stopping at an end of the tray body (11) in the length direction.

## Patentansprüche

1. Prüfsystem (200) für eine Batterie, das Folgendes umfasst:
eine Basis (21), ein Batteriefach (100), eine bewegbare Prüfanordnung (22) und ein Antriebsmittel (23);
wobei das Batteriefach (100) an der Basis (21) lösbar angeordnet ist und das Batteriefach (100) einen Fachkörper (11), eine Prüfanschlussleiste (12) und ein Positionierelement (13) aufweist;
wobei der Fachkörper (11) ausgelegt ist zum Stützen einer Batterie;
wobei die Prüfanschlussleiste (12) an dem Fachkörper (11) angeordnet ist und mehrere Signalerfassungsabschnitte (120) aufweist und die mehreren Signalerfassungsabschnitte (120) einen Stromerfassungsabschnitt (121), einen Spannungserfassungsabschnitt (122), einen Druckerfassungsabschnitt (123) und einen Temperaturerfassungsabschnitt (124) umfassen; wobei jeder Signalerfassungsabschnitt (120) zwei Signalerfassungsanschlüsse aufweist und mehrere Signalerfassungsanschlüsse entlang einer Längsrichtung der Prüfanschlussleiste (12) voneinander beabstandet sind; und
wobei das Positionierelement (13) an dem Fachkörper (11) angeordnet ist und ausgelegt ist zum Positionieren der Batterie;
wobei die Prüfanordnung (22) mehrere Signalprüfabschnitte (222) umfasst;
wobei das Antriebsmittel (23) ausgelegt ist zum Antreiben der Prüfanordnung (22), um sich so zu bewegen, dass die mehreren Signalprüfabschnitte (222) synchron mit den mehreren Signalerfassungsabschnitten (120) in Eins-zu-Eins-Entsprechung andocken; und
wobei jeder Signalprüfabschnitt (222) zwei Signalprüfsonden umfasst und mehrere Signalprüfsonden in Eins-zu-Eins-Entsprechung mit mehreren Signalerfassungsanschlüssen sind.

2. Prüfsystem (200) für eine Batterie nach Anspruch 1, wobei die Prüfanschlussleiste (12) an einem Ende des Fachkörpers (11) in einer Längsrichtung angeordnet ist und sich die Längsrichtung der Prüfanschlussleiste (12) entlang einer Breitenrichtung des Fachkörpers (11) erstreckt.

3. Prüfsystem (200) für eine Batterie nach einem der Ansprüche 1 bis 2, wobei das Batteriefach ferner Folgendes umfasst:
einen Stromerfassungsdraht, wobei der Stromerfassungsdraht mit dem Stromerfassungsabschnitt (121) verbunden ist und der Stromerfassungsabschnitt (121) über den Stromerfassungsdraht mit der Batterie verbunden ist;
einen Spannungserfassungsdraht, wobei der Spannungserfassungsdraht mit dem Spannungserfassungsabschnitt (122) verbunden ist und der Spannungserfassungsabschnitt (122) über den Spannungserfassungsdraht mit der Batterie verbunden ist;
einen Druckerfassungsdraht, wobei der Druckerfassungsdraht mit dem Druckerfassungsabschnitt (123) verbunden ist und der Druckerfassungsabschnitt (123) über den Druckerfassungsdraht mit einem Drucksensor an der Batterie verbunden ist; und
einen Temperaturerfassungsdraht, wobei der Temperaturerfassungsdraht mit dem Temperaturerfassungsabschnitt (124) verbunden ist und der Temperaturerfassungsabschnitt (124) über den Temperaturerfassungsdraht mit einem Temperatursensor an der Batterie verbunden ist.

4. Prüfsystem (200) für eine Batterie nach einem der Ansprüche 1 bis 3, wobei das Positionierelement (13) und die Prüfanschlussleiste (12) entlang einer Längsrichtung des Fachkörpers (11) voneinander beabstandet sind.

5. Prüfsystem (200) für eine Batterie nach einem der Ansprüche 1 bis 4, wobei das Positionierelement (13) Folgendes umfasst:
eine erste Positionierplatte (131), wobei sich die erste Positionierplatte (131) entlang einer Längsrichtung des Fachkörpers (11) erstreckt; und
eine zweite Positionierplatte (132), wobei sich die zweite Positionierplatte (132) entlang einer Breitenrichtung des Fachkörpers (11) erstreckt und ein Ende der zweiten Positionierplatte (132) mit einem Ende der ersten Positionierplatte (131) verbunden ist;
wobei die zweite Positionierplatte (132) direkt gegenüber der Prüfanschlussleiste (12) angeordnet ist und mindestens eine aus der ersten Positionierplatte (131) und der zweiten Positionierplatte (132) zum Stoppen der Batterie geeignet ist.

6. Prüfsystem (200) für eine Batterie nach Anspruch 5, wobei die erste Positionierplatte (131) und die zweite Positionierplatte (132) jeweils mit mehreren Positionierlöchern (130) versehen sind.

7. Prüfsystem (200) für eine Batterie nach einem der Ansprüche 1 bis 6, wobei der Fachkörper (11) mit Pufferabschnitten (14) an Außenflächen von zwei Seitenwänden in Breitenrichtung versehen ist.

8. Prüfsystem für eine Batterie nach einem der Ansprüche 1 bis 7, wobei die Prüfanordnung (22) ferner Folgendes umfasst:
eine Befestigungsbasis (221), wobei das Antriebsmittel (23) mit der Befestigungsbasis (221) zum Antreiben der Befestigungsbasis (221) verbunden ist, um sich zu bewegen, die mehreren Signalprüfabschnitte (222) an der Befestigungsbasis (221) befestigt sind, um sich synchron mit der Befestigungsbasis (221) zu bewegen, und Positionen der mehreren Signalprüfabschnitte (222) in einer Eins-zu-Eins-Entsprechung mit Positionen der mehreren Signalerfassungsabschnitte (120) sind.

9. Prüfsystem für eine Batterie nach einem der Ansprüche 1 bis 7, wobei die Basis Folgendes umfasst:
einen Stützabschnitt (211); und
zwei Rückhalteabschnitte (212), wobei die zwei Rückhalteabschnitte (212) einander in Breitenrichtung des Fachkörpers (11) gegenüberliegend angeordnet sind und auf zwei Seiten des Stützabschnitts (211) befindlich sind und sich jeder Rückhalteabschnitt (212) entlang einer Längsrichtung des Fachkörpers (11) erstreckt;
wobei der Fachkörper (11) durch den Stützabschnitt (211) gestützt wird und sich zwischen den zwei Rückhalteabschnitten (212) befindet.

10. Prüfsystem für eine Batterie nach Anspruch 9, wobei der Boden des Fachkörpers (11) einen konvexen Abschnitt (15) aufweist, der sich entlang der Längsrichtung des Fachkörpers (11) erstreckt, eine obere Oberfläche des Stützabschnitts (211) mehrere Rollabschnitte aufweist, die entlang der Längsrichtung des Fachkörpers (11) angeordnet sind, und der konvexe Abschnitt (15) in rollender Passung mit den Rollabschnitten ist.

11. Prüfsystem für eine Batterie nach Anspruch 9, wobei obere Enden der beiden Rückhalteabschnitte (212) mit Führungsabschnitten (213) versehen sind, die sich nach oben weg voneinander erstrecken.

12. Prüfsystem für eine Batterie nach Anspruch 9, wobei ein Ende des Stützabschnitts (211) weiterhin mit einem Anschlagabschnitt (214) versehen ist und der Anschlagabschnitt (214) zum Stoppen an einem Ende des Fachkörpers (11) in Längsrichtung geeignet ist.

## Revendications

1. Système de test (200) pour une batterie, comprenant :
une base (21), un support de batterie (100), un ensemble de test mobile (22) et un moyen d'entraînement (23) ;
dans lequel le support de batterie (100) est disposé de manière amovible au niveau de la base (21), et le support de batterie (100) comprend un corps de support (11), une barre de connexion de test (12) et un élément de positionnement (13) ;
dans lequel le corps de support (11) est conçu pour supporter une batterie ;
dans lequel la barre de connexion de test (12) est disposée sur le corps de support (11) et comporte une pluralité de parties de collecte de signaux (120), et la pluralité de parties de collecte de signaux (120) comprend une partie de collecte de courant (121), une partie de collecte de tension (122), une partie de collecte de pression (123) et une partie de collecte de température (124) ; dans lequel chaque partie de collecte de signaux (120) comprend deux bornes de collecte de signaux, et une pluralité de bornes de collecte de signaux sont espacées dans le sens de la longueur de la barre de connexion de test (12) ; et
dans lequel l'élément de positionnement (13) est disposé sur le corps de support (11) et conçu pour positionner la batterie ;
dans lequel l'ensemble de test (22) comprend une pluralité de parties de test de signal (222) ;
dans lequel le moyen d'entraînement (23) est conçu pour entraîner l'ensemble de test (22) en déplacement de sorte que la pluralité de parties de test de signal (222) s'amarre de manière synchrone avec la pluralité de parties de collecte de signaux (120) en une correspondance biunivoque ; et
chaque partie de test de signal (222) comprend deux sondes de test de signal, et une pluralité de sondes de test de signal sont en correspondance biunivoque avec une pluralité de bornes de collecte de signaux.

2. Système de test (200) pour une batterie selon la revendication 1, dans lequel la barre de connexion de test (12) est disposée à une extrémité du corps de support (11) dans le sens de la longueur, et le sens de la longueur de la barre de connexion de test (12) s'étend dans le sens de la largeur du corps de support (11).

3. Système de test (200) pour une batterie selon l'une quelconque des revendications 1 à 2, dans lequel le support de batterie comprend en outre :
un fil de collecte de courant, dans lequel le fil de collecte de courant est connecté à la partie de collecte de courant (121), et la partie de collecte de courant (121) est connectée à la batterie par le biais du fil de collecte de courant ;
un fil de collecte de tension, dans lequel le fil de collecte de tension est connecté à la partie de collecte de tension (122), et la partie de collecte de tension (122) est connectée à la batterie par le biais du fil de collecte de tension ;
un fil de collecte de pression, dans lequel le fil de collecte de pression est connecté à la partie de collecte de pression (123), et la partie de collecte de pression (123) est connectée à un capteur de pression sur la batterie par le biais du fil de collecte de pression ; et
un fil de collecte de température, dans lequel le fil de collecte de température est connecté à la partie de collecte de température (124), et la partie de collecte de température (124) est connectée à un capteur de température sur la batterie par le biais du fil de collecte de température.

4. Système de test (200) pour une batterie selon l'une quelconque des revendications 1 à 3, dans lequel l'élément de positionnement (13) et la barre de connexion de test (12) sont espacés dans le sens de la longueur du corps de support (11).

5. Système de test (200) pour une batterie selon l'une quelconque des revendications 1 à 4, dans lequel l'élément de positionnement (13) comprend :
une première plaque de positionnement (131), dans lequel la première plaque de positionnement (131) s'étend dans le sens de la longueur du corps de support (11) ; et
une seconde plaque de positionnement (132), dans lequel la seconde plaque de positionnement (132) s'étend dans le sens de la largeur du corps de support (11), et une extrémité de la seconde plaque de positionnement (132) est reliée à une extrémité de la première plaque de positionnement (131) ;
dans lequel la seconde plaque de positionnement (132) est disposée directement à l'opposé de la barre de connexion de test (12), et au moins l'une de la première plaque de positionnement (131) et de la seconde plaque de positionnement (132) est conçue pour arrêter la batterie.

6. Système de test (200) pour une batterie selon la revendication 5, dans lequel la première plaque de positionnement (131) et la seconde plaque de positionnement (132) sont chacune pourvues d'une pluralité de trous de positionnement (130).

7. Système de test (200) pour une batterie selon l'une quelconque des revendications 1 à 6, dans lequel le corps de support (11) est muni de parties tampons (14) sur des surfaces extérieures de deux parois latérales dans le sens de la largeur.

8. Système de test pour une batterie selon l'une quelconque des revendications 1 à 7, dans lequel l'ensemble de test (22) comprend en outre :
une base de fixation (221), dans lequel le moyen d'entraînement (23) est relié à la base de fixation (221) pour entraîner la base de fixation (221) en déplacement, la pluralité de parties de test de signal (222) sont fixées à la base de fixation (221) pour se déplacer de manière synchrone avec la base de fixation (221), et des positions de la pluralité de parties de test de signal (222) sont en correspondance biunivoque avec des positions de la pluralité de parties de collecte de signaux (120).

9. Système de test pour une batterie selon l'une quelconque des revendications 1 à 7, dans lequel la base comprend :
une partie de support (211) ; et
deux parties de retenue (212), les deux parties de retenue (212) étant disposées à l'opposé l'une de l'autre dans le sens de la largeur du corps de support (11) et situées sur deux côtés de la partie de support (211), et chaque partie de retenue (212) s'étendant dans le sens de la longueur du corps de support (11) ;
dans lequel le corps de support (11) est supporté par la partie de support (211) et situé entre les deux parties de retenue (212).

10. Système de test pour une batterie selon la revendication 9, dans lequel le fond du corps de support (11) comporte une partie convexe (15) qui s'étend dans le sens de la longueur du corps de support (11), une surface supérieure de la partie de support (211) comporte une pluralité de parties roulantes disposées dans le sens de la longueur du corps de support (11), et la partie convexe (15) est en ajustement roulant avec les parties roulantes.

11. Système de test pour une batterie selon la revendication 9, dans lequel les extrémités supérieures des deux parties de retenue (212) sont munies de parties de guidage (213) qui s'étendent vers le haut en s'éloignant l'une de l'autre.

12. Système de test pour une batterie selon la revendication 9, dans lequel une extrémité de la partie de support (211) est en outre pourvue d'une partie d'arrêt (214), et la partie d'arrêt (214) est conçue pour s'arrêter à une extrémité du corps de support (11) dans le sens de la longueur.
